Europäisches Patentamt

European Patent Office

Office européen des brevets

(19)

(11) Veröffentlichungsnummer: **0 069 985**
**A2**

## (12) EUROPÄISCHE PATENTANMELDUNG

(21) Anmeldenummer: **82106088.6**

(22) Anmeldetag: **07.07.82**

(51) Int. Cl.³: **H 01 L 23/04**
**H 01 L 23/54**

(30) Priorität: **10.07.81 DE 3127391**

(43) Veröffentlichungstag der Anmeldung:
**19.01.83 Patentblatt 83/3**

(84) Benannte Vertragsstaaten:
**DE FR GB**

(71) Anmelder: SIEMENS AKTIENGESELLSCHAFT
Berlin und München Wittelsbacherplatz 2
D-8000 München 2(DE)

(72) Erfinder: Schindlbeck, Günter, Dipl.-Ing.
Habichtstrasse 1a
D-8000 München 82(DE)

(72) Erfinder: Seher, Eugen, Ing-grad.
Sindelfinger Weg 9
D-7031 Grafenau 1(DE)

(54) Schutzanordnung für Halbleiteranordnungen.

(57) Schutzanordnung für integrierte Halbleiterschaltungen gegen durch Alpha-Strahlung verursachte flüchtige Fehler, mit einer Alpha-Strahlung abschirmenden Schutzschicht (5) auf einem das System (2) der Halbleiteranordnung einkapselnden Gehäuse (1, 4).

EP 0 069 985 A2

Croydon Printing Company Ltd.

SIEMENS AKTIENGESELLSCHAFT    Unser Zeichen
Berlin und München           VPA 81 P 1 0 9 1 E

## Schutzanordnung für Halbleiteranordnungen

Die vorliegende Erfindung betrifft eine Schutzanordnung für Halbleiteranordnungen, insbesondere integrierte Halbleiterschaltungen gegen durch Alpha-Strahlung verursachte flüchtige Fehler mit einer das System der Halbleiteranordnung gegen die Alpha-Strahlung abschirmenden Schicht beispielsweise aus organischen Verbindungen oder Kunststoffen.

Es ist bekannt, daß Alpha-Strahlung in integrierten Halbleiterschaltungen, beispielsweise in integrierten Halbleiterspeichern flüchtige Fehler (sogenannte Soft-Errors) verursacht. Dieser Sachverhalt ist beispielsweise in der Zeitschrift "Electronics" vom 11. Sept. 1980, S. 41 und 42 sowie in "IEEE Transactions on Electron Devices", Vol. ED-26, Nr. 1, Januar 1979, S. 2 - 9 beschrieben.

Zur Vermeidung von durch Alpha-Strahlung bedingten Fehlern wurde bisher eine die Alpha-Strahlung abschirmende Schutzschicht auf das System der Halbleiteranordnung, beispielsweise einer integrierten Schaltung aufgebracht. Als Material für derartige Schutzschichten kommen beispielsweise Silicone, Epoxidharze oder organische Verbindungen, wie beispielsweise ein organisches Polyimid in Frage.

Wird die Schutzschicht auf das System einer Halbleiteranordnung beispielsweise auf mechanischem oder chemischem Wege aufgebracht, so ergeben sich Ausbeute- und Zuverlässigkeitsprobleme. So kann die Schutzschicht wegen der mechanischen und thermischen Empfindlichkeit der Systeme von Halbleiteranordnungen nicht beliebig gut befestigt

Lz 1 Kth / 7.7.81

und ausgehärtet werden. Darüberhinaus werden je nach dem angewendeten Verfahren die Systemfertigung, die Meßtechnik und die Systemmontage unterschiedlich stark erschwert.

Der vorliegenden Erfindung liegt die Aufgabe zugrunde, eine Schutzanordnung der in Rede stehenden Art anzugeben, bei der die vorstehend genannten Nachteile vermieden sind.

Diese Aufgabe wird bei einer Schutzanordnung der eingangs genannten Art erfindungsgemäß dadurch gelöst, daß die Schutzschicht auf einem das System der Halbleiteranordnung einkapselnden Gehäuse vorgesehen ist.

Durch die vorstehend deffinierte Art der Anbringung der Schutzschicht werden Systeme von Halbleiteranordnungen nicht beeinträchtigt, wobei auch weder die Systemfertigung, die Messung oder die Systemmontage erschwert wird.

Darüberhinaus kann die Schutzschicht beliebig aufgebracht werden, da auf ein Gehäuse einer Halbleiteranordnung weder mechanisch noch thermisch Rücksicht genommen werden muß.

Schließlich kann das Gehäuse oder ein Gehäuseteil, auf dem die Schutzschicht vorgesehen ist, bereits vorgefertigt und als Standardelement gehandhabt werden.

Ausgestaltungen des oben definierten Erfindungsgedankens sind in Unteransprüchen gekennzeichnet.

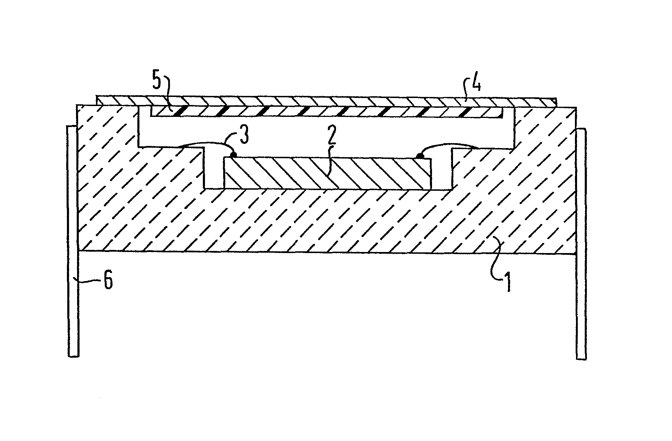

Die Erfindung wird im folgenden anhand eines in der einzigen Figur der Zeichnung dargestellten Ausführungsbeispiels näher erläutert.

Die Fig. der Zeichnung zeigt einen Schnitt einer Halbleiteranordnung, bei der ein Halbleitersystem in einem mit einer Schutzschicht versehenen Keramikgehäuse eingeschlossen ist.

Gemäß der Schnittdarstellung der Fig. der Zeichnung ist in einem Keramikgehäuse 1 ein Halbleitersystem 2, beispielsweise eine integrierten Schaltung montiert. Als System wird hier eine Halbleiterscheibe bezeichnet, welche alle Funktionselemente einer integrierten Schaltung sowie Leiterbahnen und Kontaktelektroden für den Anschluß äußerer Zuleitungen aufweist. In der Zeichnung sind schematisch Kontaktierungsdrähte 3 dargestellt, welche elektrisch auf äußere Anschlußbeine 6 der Anordnung geführt sind.

Das das Halbleitersystem 2 enthaltende Keramikgehäuse 1 wird an seiner Oberseite mit einem Deckel 4 verschlossen.

Erfindungsgemäß ist auf dieser Innenseite dieses Deckels 4 eine Alpha-Strahlung abschirmende Schicht 5 vorgesehen, welche beispielsweise aus einem der eingangs genannten Stoffe bestehen kann.

Untersuchungen haben gezeigt, daß der überwiegende Anteil der Alpha-Strahlung, welche die sogenannten Soft-Errors verursacht, aus dem Deckel des Gehäuses kommt. Dieser Anteil wird durch die Schutzschicht 5 vom System 2 abgehalten. Der Strahlungsanteil aus den Wänden des Gehäuses 1 ist in seiner Wirkung wesentlich geringer, als der aus dem Deckel stammende Anteil. Dies ist durch die vergleichsweise geringe wirksame Fläche der Wand und dem flachen Einfallswinkel dieses Strahlungsanteils bedingt. Die auf der Innenseite des Deckels 4 vorgesehene Schutzschicht 5 stellt daher einen wirksamen Schutz des Systems 2 gegen Alpha-Strahlung dar.

<u>Patentansprüche</u>

1. Schutzanordnung für Halbleiteranordnungen, insbesondere integrierte Halbleiterschaltungen gegen durch Alpha-Strahlung verursachte flüchtige Fehler mit einer das System der Halbleiteranordnung gegen die Alpha-Strahlung abschirmenden Schicht, beispielsweise aus organischen Verbindungen oder Kunststoffen, d a d u r c h  g e - k e n n z e i c h n e t,  daß die Schutzschicht (5) auf einem das System (2) der Halbleiteranordnung einkapselnden Gehäuse (1,4) vorgesehen ist.

2. Schutzanordnung nach Anspruch 1 für ein in einem Keramikgehäuse eingekapseltes System einer Halbleiteranordnung, d a d u r c h  g e k e n n z e i c h n e t,  daß die Schutzschicht (5) auf einem das Keramikgehäuse (1) vorschließenden Deckel (4) vorgesehen ist.

3. Schutzanordnung nach Anspruch 1 und 2, d a d u r c h g e k e n n z e i c h n e t,  daß die Schutzschicht (5) auf der Innenseite des Deckels (4) vorgesehen ist.

1/1